**Europäisches Patentamt**

**European Patent Office**

**Office européen des brevets**

(19)

(11) Veröffentlichungsnummer: **0 395 850**
**A2**

## EUROPÄISCHE PATENTANMELDUNG

(12)

(21) Anmeldenummer: **90103728.3**

(22) Anmeldetag: **26.02.90**

(51) Int. Cl.⁵: **H03G 3/00**

(30) Priorität: **02.05.89 DE 3914521**

(43) Veröffentlichungstag der Anmeldung:
**07.11.90 Patentblatt 90/45**

(84) Benannte Vertragsstaaten:
**CH DE FR GB IT LI SE**

(71) Anmelder: **Siemens Aktiengesellschaft**
**Wittelsbacherplatz 2**
**D-8000 München 2(DE)**

(72) Erfinder: **Schalk, Karl**
**Paumannstrasse 126**
**D-8500 Nürnberg 50(DE)**
Erfinder: **Grünewald, Uwe**
**Strengerwiesenweg 7**
**D-8500 Nürnberg 50(DE)**

(54) **Verstärker mit insbesondere binär vorgebbarem Gesamtverstärkungsfaktor.**

(57) Der erfindungsgemäße Verstärker, dessen Gesamtverstärkungsfaktor (V) innerhalb der Werte null und nahezu unendlich einstellbar ist, enthält einen internen Verstärker (SR) und einen nachgeschalteten Summenverstärker (SA). Dem internen Verstärker (SR) wird die Eingangsspannung ($U_E$) über einen Vorwiderstand (k . R) zugeführt. Er enthält ferner einen einstellbaren Rückkopplungswiderstand (V1 . R) in der Rückführung (RK). Ein erster Faktor (V1) ist innerhalb der Werte eins und nahezu unendlich vorgebbar. Ein zweiter Faktor (k) wird so vorgegeben, daß der interne Verstärker (SR) nicht übersteuert, solange das Produkt aus Gesamtverstärkungsfaktor (V) und Eingangsspannung ($U_E$) nicht erheblich außerhalb des vorgegebenen Signalbereiches ($-U_{MIN}$... $U_{MAX}$) liegt. Zur Bildung des Ausgangssignales ($U_A$) bewertet der Summenverstärker (SA) das Ausgangssignal des internen Verstärkers mit dem zweiten Faktor (k) und subtrahiert davon die Eingangsspannung ($U_E$). Als einstellbarer Rückkopplungswiderstand (V1 . R) dient bevorzugt ein Digital-Analog-Wandler mit internem Widerstandsleiternetzwerk (SN).

FIG 1

EP 0 395 850 A2

# Verstärker mit insbesondere binär vorgebbarem Gesamtverstärkungsfaktor

Die Erfindung betrifft einen Verstärker mit einem innerhalb der Werte null und nahezu unendlich einstellbaren Gesamtverstärkungsfaktor.

Bei Verstärkern ist es häufig notwendig, diverse Abgleiche vorzunehmen. Ferner ist es manchmal erforderlich, daß die Aufrechterhaltung von schaltungsspezifischen Kennwerten durch zyklisches Nachjustieren von Abgleichmitteln sichergestellt wird. Derartige Abgleiche sind z.B. notwendig, um Übereinstimmung zwischen dem vorgegebenen Verstärkungsfaktor und dem von der Schaltung tatsächlich gelieferten Verstärkungsfaktor herbeizuführen. Weitere Abgleiche sind denkbar, um beispielsweise die Übersteuerung einzelner Elemente innerhalb der Verstärkerschaltung in bestimmten Arbeitspunkten zu vermeiden. Derartige Justierungen sind aber nachteilig, da sie den Aufwand insbesondere bei der Fertigung und der Instandhaltung von Verstärkerschaltungen erhöhen.

Der Erfindung liegt die Aufgabe zugrunde, eine Verstärkerschaltung anzugeben, bei der der aktuell gewünschte Gesamtverstärkungsfaktor auf möglichst einfache und genaue Weise vorgegeben werden kann. Desweiteren sollen innerhalb der Verstärkerschaltung keine Justierungen bzw. Abgleiche herstellungs- oder anwendungsseitig notwendig sein.

Die Aufgabe wird gelöst mit der in Anspruch 1 enthaltenen Vorrichtung. Vorteilhafte weitere Ausgestaltungen der Erfindung sind in den Unteransprüchen angegeben.

Die Erfindung wird desweiteren anhand der nachfolgend kurz angeführten Figuren näher erläutert. Dabei zeigt:

FIG 1 ein Blockschaltbild des erfindungsgemäßen Verstärkers,

FIG 2 eine vorteilhafte Ausführungsform der Erfindung, bei der ein Digital-Analog-Wandler zur Vorgabe des Gesamtverstärkungsfaktors der Schaltung dient.

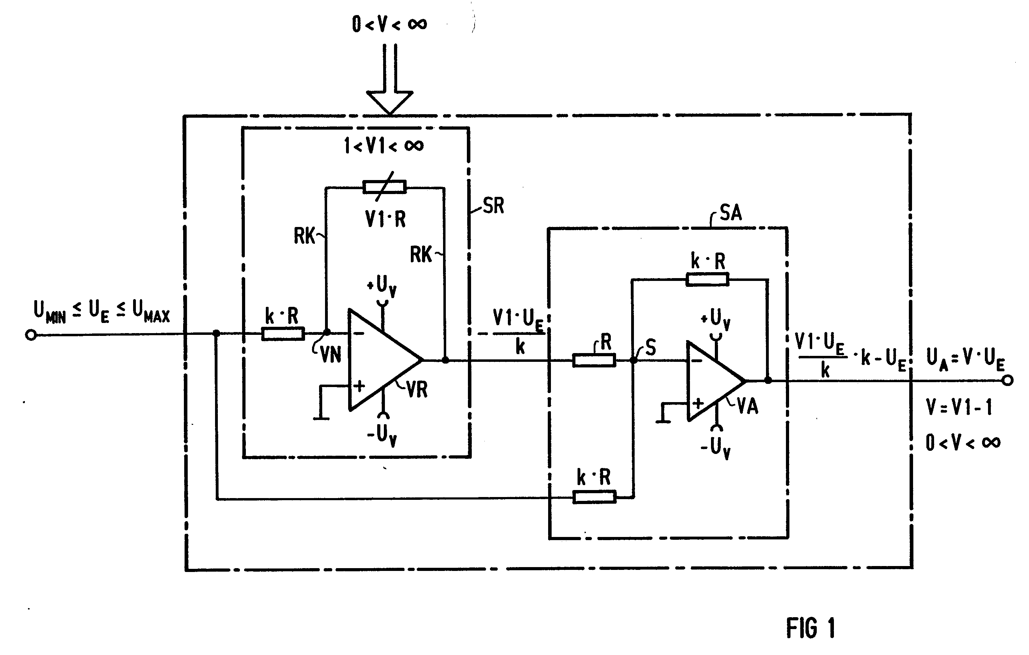

Gemäß dem Blockschaltbild von FIG 1 enthält der erfindungsgemäße Verstärker einen internen, einstellbaren Verstärker SR am Eingang und einen nachgeschalteten Summenverstärker SA am Ausgang. Der Gesamtverstärkungsfaktor V der Schaltung soll dabei im Bereich

$$0 < V < \infty$$

einstellbar sein. Ferner sei angenommen, daß für den vorgegebenen Signalbereich der Spannungen $U_E$ bzw. $U_A$ am Eingang bzw. am Ausgang des Verstärkers gilt

$$-U_{MIN} \leq U_E \leq U_{MAX}$$
$$-U_{MIN} \leq U_A \leq U_{MAX} \,.$$

Der interne Verstärker SR enthält einen Differenzverstärker VR, insbesondere einen Operationsverstärker, der mit einer positiven und negativen Versorgungsspannung $\pm U_V$ gespeist wird. Erfindungsgemäß wird dem invertierenden Eingang des Differenzverstärkers, d.h. dem davor befindlichen sogenannten virtuellen Nullpunkt VN, die Eingangsspannung $U_E$ über einen Vorwiderstand mit dem Wert $k \cdot R$ zugeführt. Dieser Vorwiderstand wird dabei bevorzugt gebildet aus einem mit einem zweiten Faktor k bewerteten, insbesondere als Normwiderstand vorgegebenen Widerstandswert R. Desweiteren ist in der Rückführung RK vom Ausgang zum virtuellen Nullpunkt VN am Eingang des Differenzverstärkers VR ein einstellbarer Rückkopplungswiderstand enthalten. Dieser wird gebildet aus dem mit einem ersten Faktor V1 bewerteten, vorgegebenen Widerstandswert R. Dieser "Normwiderstandswert" R dient bevorzugt in der gesamten Schaltung als Bezugsgröße. Der erste Faktor ist dabei zur Vorgabe des Verstärkungsfaktors des internen Verstärkers SR im Bereich

$$1 < V1 < \infty$$

einstellbar. Unter Berücksichtigung des Vorwiderstandes $k \cdot R$ entspricht der Verstärkungsfaktor des internen Verstärkers SR somit der Beziehung

$$\frac{V1}{k} \,.$$

Die Spannung an seinem Ausgang hat folglich den Wert

$$- \frac{V1 \cdot U_E}{k}$$

Dieses Signal wird dem nachgeschalteten Summenverstärker SA an einem Eingang zugeführt. Dieser enthält bevorzugt ebenfalls einen von den Versorgungsspannungen $\pm U_V$ gespeisten Operationsverstärker VA. Dieser bewertet erfindungsgemäß das Ausgangssignals des internen Verstärkers SR zum einen mit dem zweiten Faktor k und subtrahiert davon desweiteren in Bezug auf den Summenpunkt S am invertierenden Eingang die Eingangsspannung $U_E$. Bei der Ausführungsform von FIG 1 dienen hierzu der Widerstand k . R in der Rückführung des Verstärkers VA, und die Widerstände R bzw. k . R, welche an den Eingängen zur Einspeisung des Ausgangssignales des internen Verstärkers SR bzw. des Eingangssignales $U_E$ angebracht sind. Unter Berücksichtigung der invertierenden Eigenschaften des zweiten Operationsverstärkers VA ergibt sich am Ausgang des Summenverstärkers SA bzw. am Ausgang des erfindungsgemäßen Verstärkers gemäß FIG 1 die Beziehung

$$U_A = \frac{V1 \cdot U_E}{k} \cdot k - U_E = (V1 - 1) \cdot U_E = V \cdot U_E .$$

Der Gesamtverstärkungsfaktor V der erfindungsgemäßen Verstärkerschaltung entspricht somit dem um den Wert 1 reduzierten und zur Einstellung des Rückkopplungswiderstandes V1 . R des Differenzverstärkers VR im internen Verstärker SR dienenden ersten Faktor V1. Dies hat den besonderen Vorteil, daß obwohl der einstellbare Rückkopplungswiderstand aufgrund des Wertebereiches $1 < V1 < \infty$ des ersten Faktors V1 somit lediglich im Bereich $R < V1 . R < \infty$ einstellbar ist, sich für den Gesamtverstärkungsfaktor V für die gesamte Verstärkerschaltung dennoch ein Einstellbereich von $0 < V < \infty$ ergibt. Dieser ist zudem unabhängig vom konkret vorgegebenen Wert des zweiten Faktors k.

Dieser Faktor k wird erfindungsgemäß so vorgegeben, daß der Differenzverstärker VR im internen Verstärker SR in keinem Fall in die Übersteuerung geht, solange das Produkt aus dem Gesamtverstärkungsfaktor V und dem aktuellen Wert der Eingangsspannung $U_E$ nicht erheblich außerhalb des vorgegebenen Signalbereiches $-U_{MIN} \leq U_E \leq U_{MAX}$ liegt. Dies wird desweiteren anhand von zwei Beispielen näher erläutert.

Dabei sei beispielhaft angenommen, daß die vorgegebenen Signalbereichsgrenzen $-U_{MIN} ... + U_{MAX}$ jeweils die Werte ±10V und die Versorgungsspannungen $\pm U_V$ der Verstärker VR und VA jeweils die Werte ±15V haben. Desweiteren sei angenommen, daß beispielsweise ein Gesamtverstärkungsfaktor V = 1 vorgegeben ist. Dies hat zur Folge, daß für den ersten Faktor V1 der Wert 2, und somit für den einstellbaren Rückführwiderstand in der Rückkopplung RK des Verstärkers VR der Wert 2 . R eingestellt wird. Desweiteren sei angenommen, daß die Spannung $U_E$ am Eingang des erfindungsgemäßen Verstärkers gerade den oberen Wert des Signalbereiches $U_E = U_{MAX} = +10V$ aufweist.

Wird nun in einem ersten Beispiel für den zweiten Faktor k der Wert k = 1 gewählt, so müßte sich im vorliegenden Fall aufgrund der Beziehung
$\frac{V1}{k} = \frac{2}{1} = 2$
am Ausgang des internen Verstärkers SR der Wert -20V einstellen. Ein derartiger Wert ist aber nicht möglich, da aufgrund von $\pm U_V = \pm 15V$ die Ausgangsspannung des Differenzverstärkers VR auf ca. ±12V begrenzt ist. Der interne Verstärker SR ist somit übersteuert und die Gesamtverstärkerschaltung gemäß der Darstellung von FIG 1 unwirksam. Wird dagegen in einem zweiten Beispiel für den zweiten Faktor der Wert k = 2 gewählt, so ergibt sich bei Anliegen $U_E = U_{MAX} = +10V$ am Eingang von SR an dessen Ausgang ebenfalls der mit der Signalbereichsgrenze übereinstimmende Wert -10V. Es läßt sich zeigen, daß in diesem Fall der interne Verstärker SR immer innerhalb des zulässigen Arbeitsbereiches ausgesteuert wird, d.h. eine Übersteuerung vermieden wird, solange das Produkt aus der aktuell anliegenden Eingangsspannung $U_E$ und dem jeweils vorgegebenen Gesamtverstärkungsfaktor V den vorgegebenen Signalbereich von $-U_{MIN} ... + U_{MAX}$ nicht erheblich über-bzw. unterschreitet. Gemäß einer bevorzugten weiteren Ausführungsform der Erfindung hat der zweite Faktor K somit einen Wert, der größer oder gleich 2 ist.

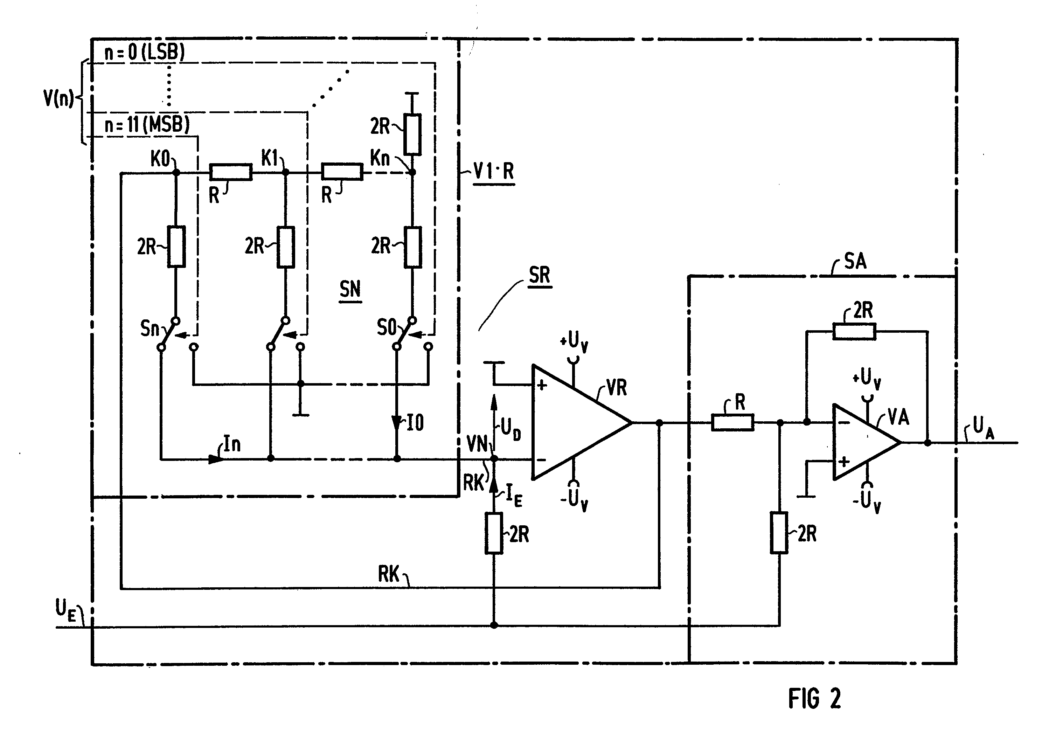

In FIG 2 ist eine weitere vorteilhafte Ausführungsform der Erfindung dargestellt. Dabei wird als einstellbarer Rückkopplungswiderstand V1 . R ein Digital-Analog-Wandler mit internem Widerstandsleitnetzwerk SN verwendet. Dieser enthält eine der Anzahl m der Stellen des binären Wortes V(n) am Eingang des Wandlers entsprechende Anzahl von Reihenschaltungen aus einem Widerstand 2 . R und einem Schaltelement Sn. Diese sind über jeweils einen Widerstand R, das eigentliche, sogenannte "R,2R"-Widerstandsleiternetzwerk bildend miteinander parallel geschaltet. Verfügt beispielsweise das binäre Wort V(n) am Eingang des Wandlers über m = 12 Stellen ("Bits") n = 0 (LSB) ... n = 11 (MSB), so sind zwölf derartige 2R Widerstandszweige mit nachgeschaltetem Schaltelement S0...Sn = S11 vorhanden. Abhängig davon, ob die jeweilige binäre Stelle den Wert logisch "1" bzw. logisch "0" hat, wird der dazugehörige Schalter Sn so betätigt, daß der dazuge hörige Widerstandszweig entweder mit dem virtuellen Nullpunkt VN am invertierenden Eingang des Differenzverstärkers VR oder mit dem Massepotential verbunden ist. Der Widerstand des in der Rückkopplung RK vom Ausgang bis zum invertierenden Eingang des Verstärkers VR befindlichen Widerstandsleiternetzwerkes SN hat somit abhängig von der aktuellen, dezimalen Wertigkeit N des am Eingang des Wandlers anliegenden binären Wortes V(n) den Wert

$$V1 \cdot R = \frac{2^m \cdot R}{N}$$

mit m = Anzahl der Stellen des binären Wortes V(n), und
$2^m - 1 \geq N \geq 1$,
$m = n - 1$.
Bei einem binären Wort V(n) mit m = 12 Stellen ergibt sich somit beispielhaft
$4095 \geq N \geq 1$
$\frac{4096}{4095} \leq V1 \cdot R \leq 4096$, d.h. näherungsweise

$1 < V1 \cdot R < \infty$.
Für den von der dezimalen Wertigkeit N des binären Wortes V(n) abhängigen Gesamtverstärkungsfaktor V des erfindungsgemäßen Verstärkers ergibt sich somit im allgemeinen

$$\frac{2^m}{2^m - 1} - 1 \leq V \leq 2^m - 1$$

$$\frac{1}{2^m - 1} \leq V \leq 2^m - 1, \quad \text{d.h. näherungsweise}$$

$$0 < V < \infty \qquad .$$

Verfügt beispielhaft das binäre Wort am Eingang des Digital-Analog-Wandlers über m = 12 Stellen n = 0 (LSB)... n = 11 (MSB), so gilt für den Gesamtverstärkungsfaktor V
$\frac{1}{4095} \leq V \leq 4095$

$0 < V < \infty$
Die erfindungsgemäße Verstärkerschaltung hat somit den Vorteil, daß derGesamtverstärkungsfaktor V innerhalb der Werte 0 und nahezu unendlich sehr genau einstellbar ist, ohne daß hierzu herstellungs- oder anwendungsseitig irgendwelche Justierungen oder Abgleiche notwendig sind. Dies trifft auch auf den zweiten Faktor k zu, welcher insbesondere bei der konkreten Schaltungsdimensionierung einmal bevorzugt auf den Wert 2 festgelegt wird, und nachfolgend keinen Veränderungen mehr unterliegt.

Die erfindungsgemäße Schaltung eignet sich desweiteren bevorzugt zum Aufbau mittels integrierter Schaltungen. Dabei kommt es weniger auf die absolute Größe des vorgegebenen Widerstandswertes R an. Im Hinblick auf die Genauigkeit des Gesamtverstärkungsfaktors V ist es lediglich notwendig, daß der Normwiderstandswert R insbesondere in der Schaltung von FIG 2 an allen Stellen gleich ist. Dies ist notwendig, da zur Bildung des aktuellen Wertes des Gesamtverstärkungsfaktors V lediglich die Verhältnisse von Widerständen beitragen, welche wiederum bevorzugt ganzzahlige Vielfache des vorgegebenen, internen Widerstandswertes R sind. Mit Hilfe von integrierten Schaltungen ist es besonders vorteilhaft möglich, genaue Widerstandsverhältniswerte vorzugeben. Die Vorgabe von stabilen und genauen Arbeitspunkten der erfindungsgemäßen Verstärkerschaltung ist somit bei Verwendung von integrierten Schaltkreisen besonders vorteilhaft möglich.

## Ansprüche

1. Verstärker mit einem innerhalb der Werte null und nahezu unendlich einstellbarem Gesamtverstärkungsfaktor (V), mit
    a) einem internen Verstärker (SR) aus
        a1) einem Differenzverstärker (VR),
        a2) einem einstellbaren Rückkopplungswiderstand (V1 . R) in der Rückführung (Rk) des Differenzverstärkers (VR), welcher aus einem mit einem ersten Faktor (V1) bewerteten Widerstandswert (R) gebildet wird, wobei der Faktor innerhalb der Werte eins und nahezu unendlich einstellbar ist,

4

a3) einem Vorwiderstand (k . R) am Eingang (VN) des Differenzverstärkers (VR), welcher aus dem mit einem zweiten Faktor (k) bewerteten Widerstandswert (R) gebildet wird, und der Faktor so vorgegeben wird, daß der Differenzverstärker nicht übersteuert, solange das Produkt aus Gesamtverstärkungsfaktor (V) und Eingangsspannung ($U_E$) nicht erheblich außerhalb des vorgegebenen Signalbereiches ($-U_{MIN}... + U_{MAX}$) liegt, und

b) einem Summenverstärker (SA), der zur Bildung des Ausgangssignals ($U_A$)

b1) das Ausgangssignal ($- \frac{V1}{k} . U_E$) des internen Verstärkers (SR) mit dem zweiten Faktor (k) bewertet, und

b2) davon die Eingangsspannung ($U_E$) subtrahiert (FIG 1).

2. Vorrichtung nach Anspruch 1, **dadurch gekennzeichnet,** daß der zweite Faktor (k) einen Wert hat, der größer oder gleich zwei ist.

3. Vorrichtung nach Anspruch 1 oder 2,**gekennzeichnet** durch einen Digital-Analog-Wandler mit internem Widerstandsleiternetzwerk (SN) als einstellbaren Rückkopplungswiderstand (V1 . R), wobei der Gesamtverstärkungsfaktor (V) durch die Wertigkeit ($4095 \geq N \geq 1$) des binären Wortes ($n = \emptyset,1,...11$) am Eingang des Digital-Analog-Wandlers eingestellt wird (FIG 2).

89 P 3218 E

FIG 1

FIG 2

EP 0 395 850 A2

89 P 3218 E